# EUROPÄISCHE PATENTSCHRIFT

(11) **EP 0 898 733 B1**
(45) Veröffentlichungstag und Bekanntmachung des Hinweises auf die Patenterteilung: **28.11.2001**
(21) Anmeldenummer: 97921512.6
(22) Anmeldetag: 13.05.1997
(51) Int. Cl.: G03F 1/16

(54) **VERFAHREN ZUR HERSTELLUNG EINER STENCIL-MASKE**
METHOD OF PRODUCING A STENCIL MASK
PROCEDE DE PRODUCTION D'UN MASQUE DE STENCIL

(30) Priorität: 13.05.1996 AT 84496; 06.09.1996 AT 158796
(43) Veröffentlichungstag der Anmeldung: 03.03.1999
(73) Patentinhaber: Infineon Technologies AG, 81669 München (DE)
(72) Erfinder: HAMMEL, Ernst, NL-2271 EK Voorburg (NL); LÖSCHNER, Hans, A-1190 Wien (AT); RANGELOW, Ivaylo, W., D-34225 Baunatal (DE)
(74) Vertreter: Zedlitz, Peter, Dipl.-Inf.
(86) Internationale Anmeldenummer: AT9700096
(87) Internationale Veröffentlichungsnummer: WO9743694

(56) Entgegenhaltungen:
- EP-A- 0 019 779
- EP-A- 0 542 519
- DE-A- 19 527 314
- US-A- 4 013 502

## Beschreibung

Die vorliegenden Erfindung betrifft ein Verfahren zur Herstellung einer Stencil-Maske, nämlich eine Anordnung, welche unter anderem eine ebene Folie mit mehreren Durchbrechungen aufweist.

Die Herstellung von Stencil-Masken ist insbesondere dann schwierig, wenn Sie großflächig bei einer geringen Dicke hergestellt werden sollen, z.B. mit einem Durchmesser größer als 5cm und einer Dicke im Bereich von 0,25 bis 50µm, und überdies eine Öffnungsstruktur mit äußerst kleinen Abmessungen im µm- oder sub-µm-Bereich besitzen sollen. Masken dieser Art werden bei einer Vielzahl von Prozessen, z.B. bei lithographischen Anwendungen, zur Ionenimplantation, zum lonenstrahlätzen, Aufdampfen, sowie als Gitterlinsen od. dgl. verwendet.

Bekannte Herstellungsverfahren umfassen im allgemeinen das Dünnätzen von dicken Substraten, z.B. von Silizium-Wafem. Die Öffnungsstruktur der Maske kann entweder vor oder nach dem Dünnätzen des Substrates mittels eines lithographischen Verfahrens erzeugt werden. Im ersten Fall (Maskenstruktur wird vor dem Dünnätzen erzeugt) ist es erforderlich, die Öffnungsstruktur während des Dünnätzens vor einem Ätzangriff zu schützen, z.B. durch Auffüllen mit einem bestimmten Material, welches danach restlos wieder entfernt werden muß. Ein Verfahren dieser Art wird in der US-4,013,502 gelehrt; eine ähnliche Vorgangsweise offenbart auch die EP 0 019 779 A. Im zweiten Fall (Öffnungsstruktur wird nach dem Dünnätzen erzeugt) müssen alle für die Strukturierung erforderlichen Bearbeitungsschritte auf der dünnen Folie durchgeführt werden, sodaß diese leicht beeinträchtigt oder beschädigt werden kann.

In der EP 0 542 519 A ist ab Zeile 28 der Spalte 8 ein Verfahren zur Herstellung einer Maskenstruktur beschrieben, bei dem die Rückseite des Wafers bis auf Membrandicke weggeätzt wird und dann das Design der Maske auf der Oberseite der Membran lithographisch erzeugt wird. Der Ätzstop der Membran wird durch die Dotierung einer Schichte erreicht, wobei die Dotierung derart hochkonzentriert sein muß, daß dadurch eine sehr hohe Spannung in der Membran entsteht. Zur Kompensation dieser Spannung dient eine Beschichtung in Form eines Mehrschicht-Dielektrikums ('multilayer dielectric coating').

Ein Nachteil dieser bekannten Herstellungsverfahren liegt somit unter anderem darin, daß sowohl das Schützen der Öffnungen als auch die spätere Weiterbehandlung einer Folie oder Membran sehr aufwendig und daher teuer sind.

Es ist daher eine Aufgabe der vorliegenden Erfindung, unter Vermeidung der oben genannten Nachteile ein neuartiges Verfahren zur Herstellung von Stencil-Masken zu schaffen, welches einfach und kostengünstig ausgeführt werden kann und die mechanischen Spannungseigenschaften während der Herstellung möglichst wenig verändert. Insbesondere sollten dabei bereits bekannte und leicht beherrschbare Herstellungstechnologien eingesetzt werden können, z.B. Technologien, die zur Halbleiterfertigung entwickelt wurden.

Diese Aufgaben werden erfindungsgemäß bei einem Verfahren gelöst, welches die folgenden, nacheinander ausgeführten Schritte aufweist:
a) Auswählen eines ebenen flächigen Substrates aus einem bestimmten Material mit einer Dicke größer als 50µm,
b) Herstellen einer dünnen Schicht, der sogenannten Zwischenschicht an der Oberseite des Substrates,
c) Strukturieren dieser Zwischenschicht mittels eines lithographischen Verfahrens mit den Strukturen für die herzustellende Maske,
d) Ätzen der Unterseite des Substrates zumindest im Bereich der für die Maskenöffnungen vorgesehenen Strukturen, bis das Substrat in diesem Bereich eine vorbestimmte Membrandicke kleiner als 50µm aufweist,
e) Ätzen der Oberseite der Membran unter Verwendung der strukturierten Zwischenschicht als Maskierungsschicht, um in dieser Membran die Öffnungen für die Stencil-Maske auszubilden, die den Strukturen der Zwischenschicht entsprechen, und
f) Entfernen der Zwischenschicht.

Durch diese Abfolge von Schritten, werden die für die Strukturierung erforderlichen Verfahrensschritte, welche mechanische Belastungen verursachen, bereits vor dem Dünnätzen vorgenommen, während das Ätzen der Maskenöfihungen selbst erst nach dem Dünnätzen erfolgt, um eine Verunreinigung oder Beeinträchtigung dieser Öffnungen während des Dünnätzens zu verhindern.

Vorteilhafte Ausgestaltungsformen des erfindungsgemäßen Verfahrens gehen aus den abhängigen Unteransprüchen hervor.

Weitere Merkmale und Vorteile des erfindungsgemäßen Verfahrens ergeben sich aus der nachfolgenden, nicht einschränkenden Beschreibung von Ausführungsbeispielen, wobei auf die beiliegenden Figuren Bezug genommen wird, die folgendes zeigen:
Fig. 1a bis 1j ein erstes Ausführungsbeispiel zur Durchführung des Verfahrens,
Fig. 2a bis 2j ein zweites Ausführungsbeispiel zur Durchführung des Verfahrens und
Fig. 3a bis 3i schematisch eine Abfolge von Schritten zur Durchführung des erfindungsgemäßen Verfahrens.

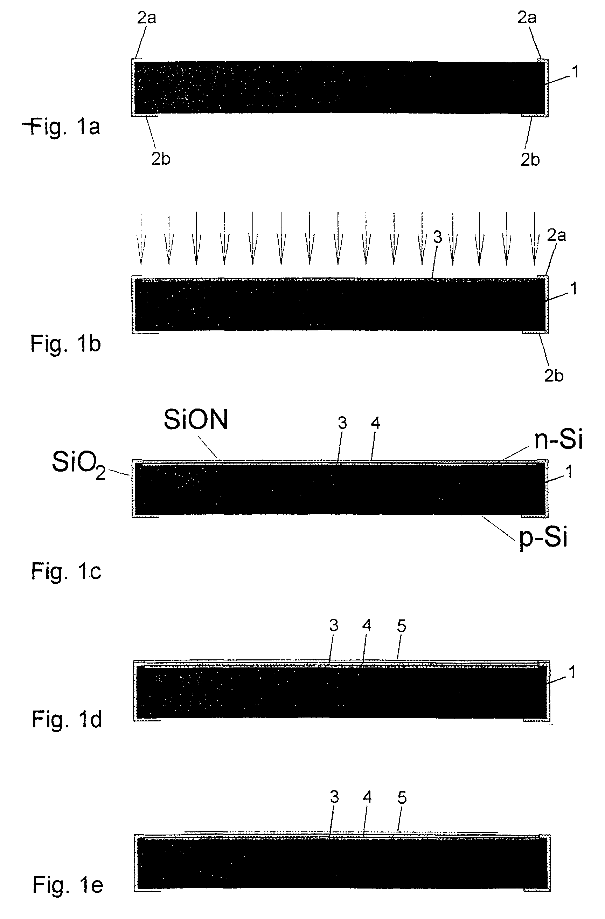

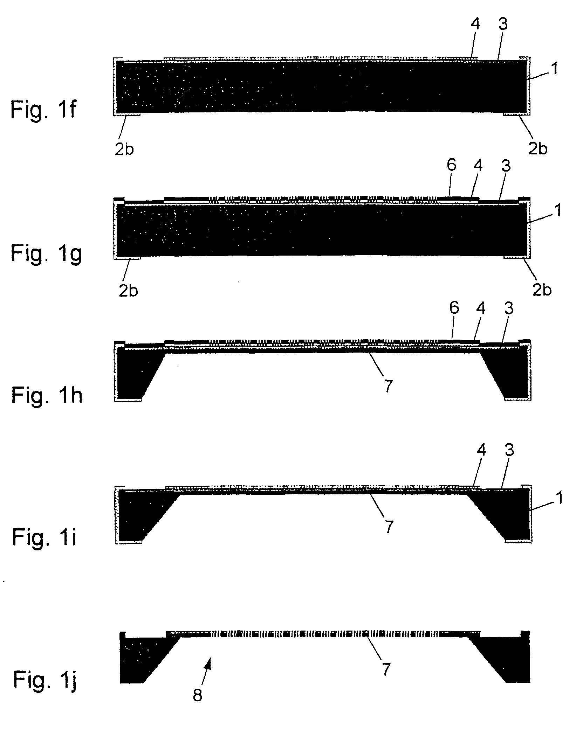

Vorerst wird auf die Figuren 1a bis 1j Bezug genommen, die schematisch ein erstes, nicht einschränkendes Ausführungsbeispiel des erfindungsgemäßen Verfahrens veranschaulichen.

Fig. 1a zeigt ein flächiges Halbleiter-Substrat 1 eines bestimmten Leitfähigkeitstyps, z.B. einen p-leitenden Silizium Wafer, der entlang seiner Berandung sowohl an der Oberseite als auch an der Unterseite mit einer Maskierung 2a, 2b versehen ist, z.B. eine Siliziumoxid-Schicht um diese Berandung bei den nachfolgenden Verfahrensschritten von einer Bearbeitung auszunehmen.

In dem nachfolgenden, in Fig. 1b schematisch dargestellten Verfahrensschritt wird die innerhalb des maskierten Bereichs 2a befindliche Oberseite des Substrates 1 dotiert, z.B. durch Ionenimplantation mit Phosphor- oder Arsen-Ionen, um an dieser Oberseite eine n-dotierte Schicht 3 mit einer vorbestimmten Dicke herzustellen. Die Auswahl des Dotiermaterials, die Dotiertiefe und die Dotierungskonzentration hängt im wesentlichen von dem später verwendeten Dünnätzverfahren und von den gewünschten Spannungseigenschaften der herzustellenden Maske ab. Die hiefür erforderlichen Parameter sind dem Fachmann auf diesem Gebiet bekannt und werden an dieser Stelle daher nicht näher erläutert. Insbesondere wird in diesem Zusammenhang auf parallele Anmeldungen der Anmelderin verwiesen, unter anderem auf die Anmeldungen DE 195 27 314 und PCT AT95/00111, die ausdrücklich als ein Teil dieser Offenbarung anzusehen sind.

Üblicherweise wird der durch Ionenbeschuß implantierte Dotierstoff nach der IonenImplantation durch thermisches Ausheilen (thermal annealing) des Substrates aktiviert.

Auf der Oberseite der dotierten Schicht 3 des Substrates 1 wird sodann eine dünne Zwischenschicht 4, z.B. eine SiON-Schicht mit einer Dicke von 1 µm hergestellt, die thermisch in einer mit Sauerstoff und Stickstoff angereicherten Atmosphäre aufwächst (Fig. 1c). Als eine Zwischenschicht kann in dem vorliegenden Fall eines Silizium-Wafers auch eine reine Oxidschicht (SiO₂) oder eine reine Nitridschicht (Si₃N₄) aufgetragen werden. Ebenso können im Rahmen der vorliegenden Erfindung andere strutkurierbare Schichten hergestellt werden, z.B. aufgedampfte, chemisch oder elektrochemisch hergestellte Schichten, welche für die nachfolgende Bearbeitung ausreichend stabil sind.

Die Zwischenschicht 4 wird in der Folge mittels eines lithographischen Verfahrens mit den Strukturen der herzustellenden Maske strukturiert. Zu diesem Zweck wird auf die Oberseite der Zwischenschicht 4 eine Resistschicht 5 aufgetragen, die in geeigneter Weise belichtet und entwickelt wird. Danach wird die Zwischenschicht 4 in den strukturierten Bereichen bis zur Oberseite des Substrates 1 geätzt und die noch vorhandene Resistschicht entfernt (Fig. 1e, 1f). Lithographische Verfahren dieser Art sind dem Fachmann bekannt und werden an dieser Stelle ebenso nicht im Detail erläutert.

In der Folge wird auf die strukturierte Zwischenschicht 4 eine leitfähige Schutzschicht, z.B. eine Metallschicht 6 (wie TiW) aufgedampft oder abgeschieden (Fig. 1g). Diese Metallschicht 6 hat in dem vorliegenden Fall eine Doppelfunktion, nämlich einerseits die Strukturen der Zwischenschicht vor einem Ätzangriff zu schützen, andererseits eine Elektrode für das nachfolgende elektrochemische Ätzstopp-Verfahren zu bilden.

Durch das bereits angesprochene elektrochemische Ätzstopp-Verfahren wird das Substrat von der Unterseite in dem Bereich innerhalb der maskierten Berandung 2b geätzt, bis in diesem Bereich eine Membran 7 mit einer vorbestimmten Dicke, z.B. mit einigen µm Dicke übrig bleibt. Bei einem elektrochemischen Ätzstopp-Verfahren wird der Ätzprozeß automatisch durch eine elektrochemische Passivierung kurz vor Erreichen des p/n-Überganges in der Nähe der Grenzfläche zwischen dem undotierten Substrat 1 und der dotierten Schicht 3 gestoppt. Ein Verfahren dieser Art zum Dünnätzen von Silizium-Substraten ist unter anderem in den europäischen Anmeldungen EP 367 750 und EP 399 998 der Anmelderin ausführlich beschrieben. Der Offenbarungsgehalt dieser europäischen Anmeldungen ist somit ausdrücklich auch als ein Teil der vorliegenden Offenbarung anzusehen. Im Rahmen der vorliegenden Erfindung sind jedoch auch alle anderen bekannten Verfahren zum Dünnätzen eines Substrates einsetzbar.

Nach dem (in Fig. 1h veranschaulichten) Dünnätzen wird die Metall-Schutzschicht 6 an der Oberseite der strukturierten Schicht 4 entfernt, sodaß die Strukturen dieser Maskierungsschicht wieder zum Vorschein kommen (Fig. 1i). Bei Verwendung einer TiW-Schutzschicht empfiehlt sich Wasserstoffperoxid (H₂O₂) zum Entfernen dieser Schicht.

Zur Herstellung einer Stencil-Maske 8 wird die Membran 7 nun durch die Strukturen der Zwischenschicht 4 geätzt, z.B. durch reaktives Ionenstrahlätzen, bis in diesen nicht maskierten Bereichen der Membran 7 Öffnungen entstehen, welche die Strukturen der Maske 8 bilden. Die Zwischenschicht 4 wird abschließend entfernt. Figur 1j zeigt die Stencil-Maske unmittelbar nach Beendigung des Herstellungsverfahrens.

In den Figuren 1e bis 1j ist weiters zu sehen, daß im Bereich der Berandung der Maske Strukturen vorgesehen sind, die nicht als Öffnungen ausgebildet sind. Diese, nicht näher bezeichneten Strukturen dienen üblicherweise zur Ausrichtung der Maske.

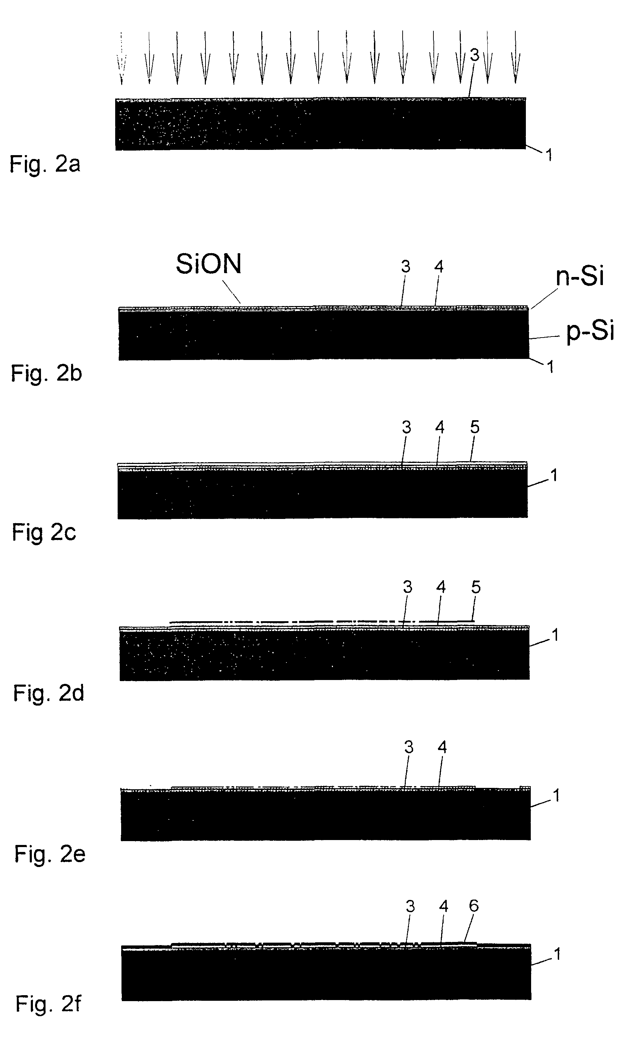

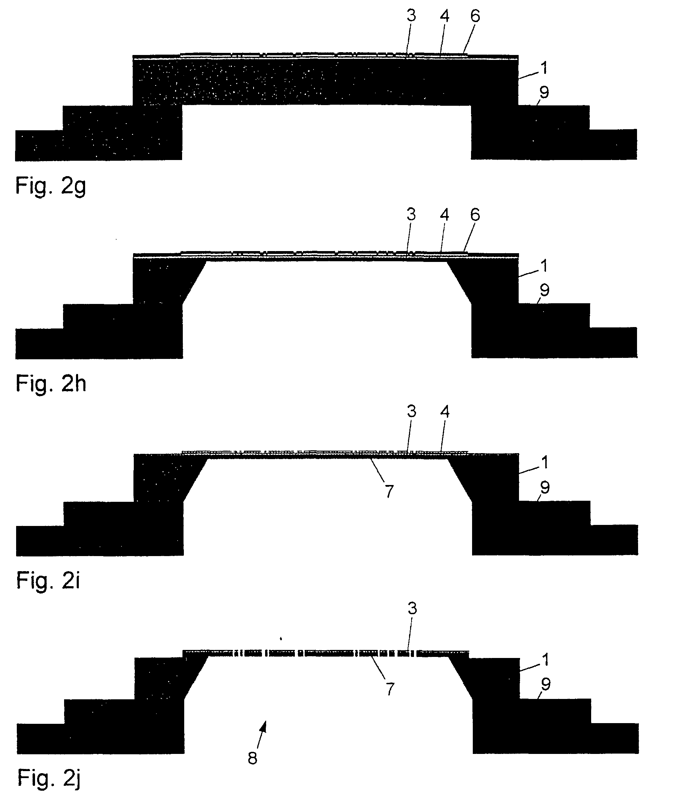

In den Figuren 2a bis 2j ist ein weiteres, nicht einschränkendes Ausführungsbeispiel für das erfindungsgemäße Verfahren schematisch dargestellt.

Wie in Figur 2a zu sehen ist, werden im Unterschied zu dem oben beschriebenen Ausführungsbeispiel (vgl. Fig. 1a) an den Berandungen des Substrates 1 vorerst keine Maskierungen hergestellt.

Die in den Figuren 2a bis 2f dargestellten Verfahrensschritte entsprechen im wesentlichen den in den Figuren 1b bis 1g dargestellten und weiter oben im Detail beschriebenen Verfahrensschritte, sodaß diese Verfahrensschritte hier nicht nochmals beschrieben werden.

Figur 2g ist zu entnehmen, daß das Substrat 1 nun mit seiner Unterseite entlang der Berandung an einem stabilen Rahmen 9 befestigt wird, z.B. einem Pyrex- oder einem Silizium-Ring.

Mit diesem Rahmen 9 wird das Substrat 1 nun der weiteren Bearbeitung zugeführt. Die nachfolgenden, in den Figuren 2h bis 2j dargestellten Verfahrensschritte entsprechen im wesentlichen den Verfahrensschritten, die in den Figuren 1h bis 1j dargestellt und mit Bezug auf diese Figuren weiter oben beschrieben sind. Daher wird an dieser Stelle nicht nochmals darauf eingegangen.

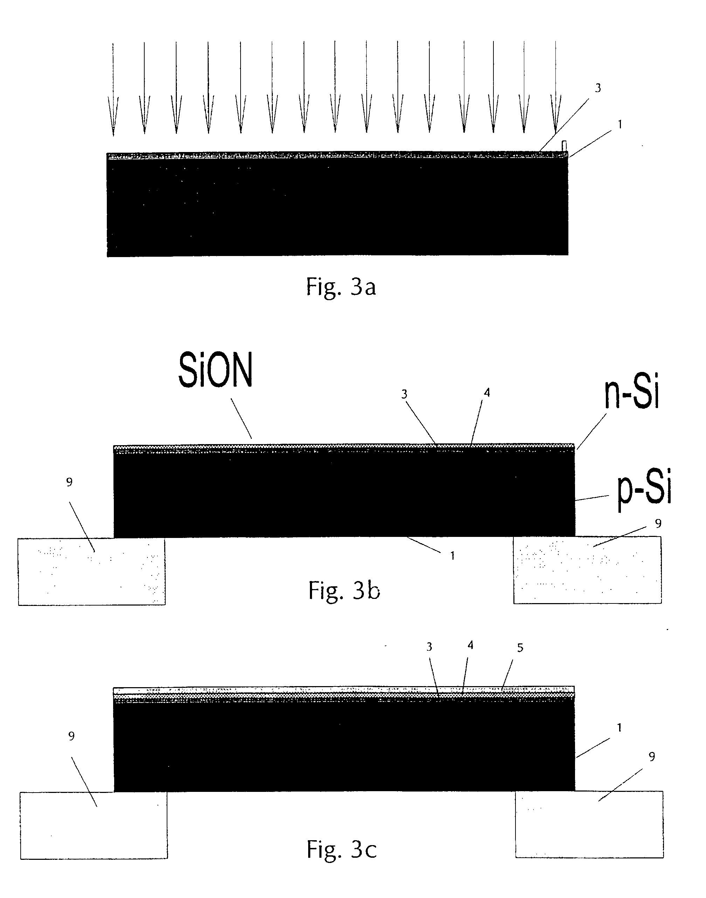

Mit Bezug auf die schematischen Figuren 3a bis 3i ist zu bemerken, daß deren vertikaler Maßstab stark übertrieben dargestellt ist und der besseren Übersicht halber in den Figuren 3a bis 3f stärker vergrößert ist als in den Figuren 3g bis 3i. Fig. 3a zeigt ein flächiges Halbleiter-Substrat 1 eines bestimmten Leitfähigkeitstyps, z.B. einen p-leitenden Silizium Wafer, der an seiner Oberseite dotiert wird, z.B. durch Ionenimplantation mit Phosphor-oder Arsen-Ionen, um an dieser Oberseite eine n-dotierte Schicht 3 mit einer vorbestimmten Dicke herzustellen. Die Auswahl des Dotiermaterials, die Dotiertiefe und die Dotierungskonzentration hängt im wesentlichen von dem später verwendeten Dünnätzverfahren und von den gewünschten Spannungseigenschaften der herzustellenden Maske ab. Die hiefür erforderlichen Parameter sind dem Fachmann auf diesem Gebiet bekannt und werden an dieser Stelle daher nicht näher erläutert. Insbesondere wird in diesem Zusammenhang auf parallele Anmeldungen der Anmelderin verwiesen, unter anderem auf die Anmeldungen DE 195 27 314 und PCT AT95/00111, die ausdrücklich als ein Teil dieser Offenbarung anzusehen sind.

Üblicherweise wird der durch Ionenbeschuß implantierte Dotierstoff nach der IonenImplantation durch thermisches Ausheilen (thermal annealing) des Substrates aktiviert.

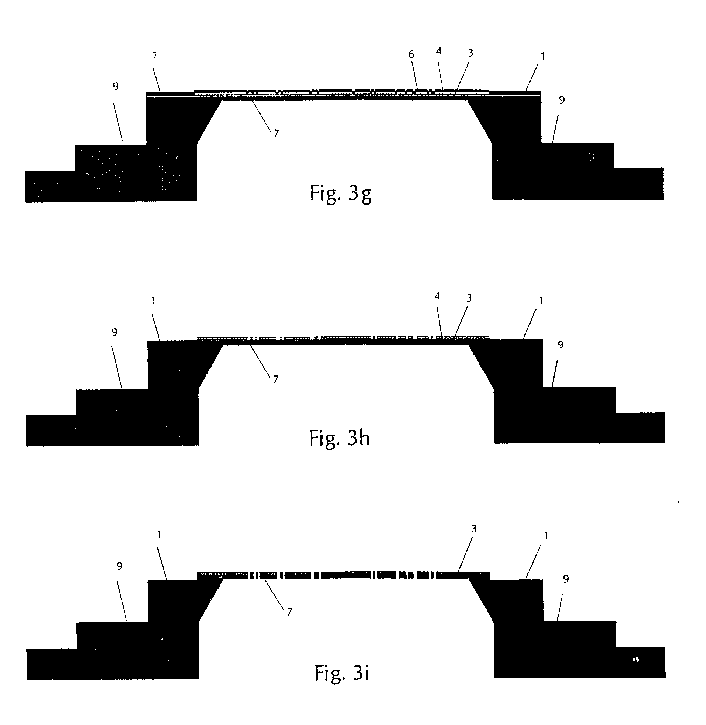

Auf der Oberseite der dotierten Schicht 3 des Substrates 1 wird sodann eine dünne Zwischenschicht 4, z.B. eine SiON-Schicht mit einer Dicke von 1 µm hergestellt, die thermisch in einer mit Sauerstoff und Stickstoff angereicherten Atmosphäre aufwächst (Fig. 3b). Als eine Zwischenschicht kann in dem vorliegenden Fall eines Silizium-Wafers auch eine reine Oxidschicht (SiO₂) oder eine reine Nitridschicht (Si₃N₄) aufgetragen werden. Ebenso können im Rahmen der vorliegenden Erfindung andere strukturierbare Schichten hergestellt werden, z.B. aufgedampfte, chemisch oder elektrochemisch hergestellte Schichten, welche für die nachfolgende Bearbeitung ausreichend stabil sind.

Figur 3b ist weiters zu entnehmen, daß das Substrat 1 nun mit seiner Unterseite entlang der Berandung an einem stabilen Rahmen 9 befestigt wird, z.B. einem Pyrex- oder einem Silizium-Ring. Mit diesem Rahmen 9 wird das Substrat 1 nun der weiteren Bearbeitung zugeführt.

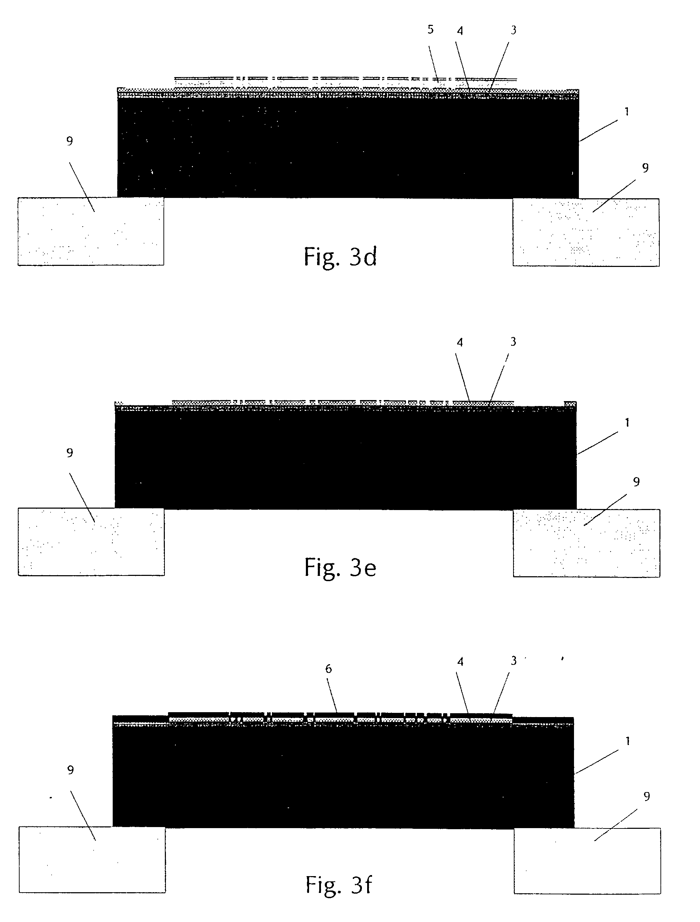

Die Zwischenschicht 4 wird in der Folge mittels eines lithographischen Verfahrens mit den Strukturen der herzustellenden Maske strukturiert. Zu diesem Zweck wird auf die Oberseite der Zwischenschicht 4 eine Resistschicht 5 aufgetragen (Fig. 3c), die in geeigneter Weise belichtet und entwickelt wird. Danach wird die Zwischenschicht 4 in den strukturierten Bereichen bis zur Oberseite des Substrates 1 geätzt und die noch vorhandene Resistschicht entfernt (Fig. 3d, 3e). Lithographische Verfahren dieser Art sind dem Fachmann bekannt und werden an dieser Stelle ebenso nicht im Detail erläutert.

In der Folge wird auf die strukturierte Zwischenschicht 4 eine leitfähige Schutzschicht, z.B. eine Metallschicht 6 (wie TiW) aufgedampft oder abgeschieden (Fig. 3f). Diese Metallschicht 6 hat in dem vorliegenden Fall eine Doppelfünktion, nämlich einerseits die Strukturen der Zwischenschicht vor einem Ätzangriff zu schützen, andererseits eine Elektrode für das nachfolgende elektrochemische Ätzstopp-Verfahren zu bilden.

Durch das bereits angesprochene elektrochemische Ätzstopp-Verfahren wird das Substrat von der Unterseite in dem Bereich innerhalb des Ringes 9 geätzt, bis in diesem Bereich eine Membran 7 mit einer vorbestimmten Dicke, z.B. mit einigen µm Dicke übrig bleibt. Bei einem elektrochemischen Ätzstopp-Verfahren wird der Ätzprozeß automatisch durch eine elektrochemische Passivierung kurz vor Erreichen des p/n-Überganges in der Nähe der Grenzfläche zwischen dem undotierten Substrat 1 und der dotierten Schicht 3 gestoppt. Ein Verfahren dieser Art zum Dünnätzen von Silizium-Substraten ist unter anderem in den europäischen Anmeldungen EP 367 750 und EP 399 998 der Anmelderin ausführlich beschrieben. Der Offenbarungsgehalt dieser europäischen Anmeldungen ist somit ausdrücklich auch als ein Teil der vorliegenden Offenbarung anzusehen. Im Rahmen der vorliegenden Erfindung sind jedoch auch alle anderen bekannten Verfahren zum Dünnätzen eines Substrates einsetzbar.

Nach dem (in Fig. 2g veranschaulichten) Dünnätzen wird die Metall-Schutzschicht 6 an der Oberseite der strukturierten Schicht 4 entfernt, sodaß die Strukturen dieser Maskierungsschicht wieder zum Vorschein kommen (Fig. 3h). Bei Verwendung einer TiW-Schutzschicht empfiehlt sich Wasserstoffperoxid (H₂O₂) zum Entfernen dieser Schicht.

Zur Herstellung einer Stencil-Maske 8 wird die Membran 7 nun durch die Strukturen der Zwischenschicht 4 geätzt, z.B. durch reaktives Ionenstrahlätzen, bis in diesen nicht maskierten Bereichen der Membran 7 Öffnungen entstehen, welche die Strukturen der Maske 8 bilden. Die Zwischenschicht 4 wird abschließend entfernt. Figur 3i zeigt die Stencil-Maske unmittelbar nach Beendigung des Herstellungsverfahrens.

Abschließend ist noch zu erwähnen, daß die dargestellten und beschriebenen Ausführungsbeispiele nur zur näheren Erläuterung des erfindungsgemäßen Verfahrens dienen und somit keine Einschränkung darstellen. Die Art der verwendeten Materialien und deren Bearbeitung sind im Rahmen der vorliegenden Erfindung beliebig, solange die Verfahrensschritte gemäß dem nachfolgenden Hauptanspruch realisierbar sind.

## Patentansprüche

1. Verfahren zur Herstellung einer Stencil-Maske, welche eine Folie mit Strukturen in Form von Öffnungen aufweist, wobei das Verfahren die folgenden, nacheinander ausgeführten Schritte aufweist:
a) Auswählen eines ebenen flächigen Substrates aus einem bestimmten Material mit einer Dicke größer als 50µm,
b) Herstellen einer dünnen Schicht, der sogenannten Zwischenschicht, an der Oberseite des Substrates,
c) Strukturieren dieser Zwischenschicht mittels eines lithographischen Verfahrens mit den Strukturen für die herzustellende Maske,
d) Ätzen der Unterseite des Substrates zumindest im Bereich der für die Maskenöffnungen vorgesehenen Strukturen, bis das Substrat in diesem Bereich eine vorbestimmte Membrandicke kleiner als 50µm aufweist,
e) Ätzen der Oberseite der Membran unter Verwendung der strukturierten Zwischenschicht als Maskierungsschicht, um in dieser Membran die Öffnungen der Maske auszubilden, die den Strukturen der Zwischenschicht entsprechen, und
f) Entfemen der Zwischenschicht.

2. Verfahren nach Anspruch 1, **dadurch gekennzeichnet, dass** bei Ausführen des Schrittes d) ein elektrochemisches Ätzverfahren angewendet wird, wobei die strukturierte Zwischenschicht zuvor mit einer leitenden Schicht überzogen wird, die nach dem Ätzvorgang wieder von der Zwischenschicht entfernt wird.

3. Verfahren nach Anspruch 1 oder 2, **dadurch gekennzeichnet, dass** das Substrat eine Silizium-Scheibe mit einem bestimmten Leitfähigkeitstyp, z.B. ein p-leitender Silizium-Wafer ist, und dass bei Ausführen des Schrittes a) für das Substrat ein Halbleitermaterial ausgewählt wird, welches an der Oberseite innerhalb einer vorbestimmten Dicke mit einem Dotierstoff dotiert ist, welcher im Vergleich mit dem Substrat einen entgegengesetzten Leitfähigkeitstyp aufweist, z.B. n-leitend wie Phosphor oder Arsen oder eine Mischung dieser Stoffe ist.

4. Verfahren nach Anspruch 3, **dadurch gekennzeichnet, dass** die Zwischenschicht Siliziumnitrid (Si₃N₄) oder Siliziumoxinitrid (SiON) ist.

5. Verfahren nach Anspruch 2, **dadurch gekennzeichnet, dass** die leitende Schicht eine Metallschicht ist, z.B. Titan, Wolfram oder TiW ist.

6. Verfahren nach einem der Ansprüche 1 bis 5, **dadurch gekennzeichnet, dass** die Unterseite des Substrates vor Ausführen des Schrittes d) entlang der Berandung des Substrates vor einem Ätzangriff geschützt wird, z.B. durch Auftragen einer Passivierungsschicht oder durch Anbringen eines Rahmens.

7. Verfahren nach einem der Ansprüche 1 bis 6, **dadurch gekennzeichnet, dass** an dem Substrat vor Ausführen eines der Schritte b), c) oder d) im Bereich der Berandung des Substrates ein stabiler Rahmen (9) befestigt wird.

8. Verfahren nach Anspruch 7, **dadurch gekennzeichnet, dass** für den Rahmen ein Pyrex- oder Siliziumring ausgewählt wird und dieser Ring vor Ausführen des Schrittes b) an dem Substrat befestigt wird.

## Claims

1. Method for producing a stencil mask which comprises a foil having structures realised as orifices, wherein the method comprises the following sequence of steps:
a) selecting a flat planar substrate consisting of a specific material having a thickness greater than 50 µm,
b) producing a thin layer, the so-called intermediate layer, on the upper side of the substrate,
c) structuring this intermediate layer by means of a lithographic process with the structures for the mask to be produced,
d) etching the lower side of the substrate at least in the region of the structures provided for the mask orifices, until the substrate comprises in this region a predetermined membrane thickness less than 50 µm,
e) etching the upper side of the membrane using the structured intermediate layer as a making layer in order to form the orifices of the mask in this membrane, the orifices corresponding to the structures of the intermediate layer, and
f) removing the intermediate layer.

2. Method according to claim 1, **characterised in that** on performing step d) an electrochemical etching process is used, wherein beforehand the structured intermediate layer is coated with a conductive layer which is removed from the intermediate layer after the etching procedure.

3. Method according to claim 1 or 2, **characterised in that** the substrate is a silicon disc having a specific conductivity type, e.g. a p-type silicon wafer, and on performing step a) a semiconductor material which is doped with a doping substance on the upper side within a predetermined thickness is selected for the substrate, the doping substance having, in comparison with the substrate, an opposite conductivity type, e.g. n-type such as phosphorus or arsenic or a mixture of these substances.

4. Method according to claim 3, **characterised in that** the intermediate layer is silicon nitride (Si₃N₄) or silicon oxinitride (SiON).

5. Method according to claim 2, **characterised in that** the conductive layer is a metal layer, e.g. titanium, tungsten or TiW.

6. Method according to any one of claims 1 to 5, **characterised in that** before performing step d) the lower side of the substrate is protected from being etched along the edging of the substrate, e.g. by applying a passivation layer or attaching a frame.

7. Method according to any one of claims 1 to 5, **characterised in that** before performing one of the steps b), c) or d) a stable frame (9) is attached to the substrate in the region of the edging of the substrate.

8. Method according to claim 7, **characterised in that** a Pyrex or silicon ring is selected for the frame and this ring is attached to the substrate before performing step b).

## Revendications

1. Procédé de production d'un masque de stencil, qui comporte une feuille ayant des structures sous la forme d'ouvertures, le procédé comprenant les stades suivants exécutés successivement :
a) choix d'un substrat plan et plat en un matériau déterminé et en une épaisseur supérieure à 50 µm,
b) production d'une couche mince dénommée couche intermédiaire sur la face supérieure du substrat,
c) structuration de cette couche intermédiaire au moyen d'un procédé lithographique de manière à lui donner les structures pour le masque à produire,
d) attaque chimique de la face inférieure du substrat au moins dans la région des structures prévues pour les ouvertures du masque jusqu'à ce que le substrat ait, dans cette région, une épaisseur de membrane déterminée à l'avance inférieure à 50 µm,
e) attaque chimique de la face supérieure de la membrane en utilisant la couche intermédiaire structurée comme couche de masquage et constitution dans cette membranes des ouvertures du masque, qui correspondent aux structures de la couche intermédiaire et
f) élimination de la couche intermédiaire.

2. Procédé suivant la revendication 1, **caractérisé en ce que**, lorsque l'on effectue le stade d), on utilise un procédé d'attaque électrochimique, la couche intermédiaire structurée étant d'abord revêtue d'une couche conductrice qui est éliminée à nouveau de la couche intermédiaire après l'opération d'attaque.

3. Procédé suivant la revendication 1 ou 2, **caractérisé en ce que** le substrat est un disque de silicium ayant un type de conductivité déterminé, par exemple une tranche de silicium de conductivité p et **en ce que**, lorsque l'on effectue le stade a), on choisit pour le substrat un matériau semi-conducteur qui est dopé sur la face supérieure en une épaisseur déterminée à l'avance d'une substance de dopage qui a, par rapport au substrat, un type de conductivité opposé, par exemple en étant de conductivité n, comme du phosphore ou de l'arsenic ou un mélange de ces substances.

4. Procédé suivant la revendication 3, **caractérisé en ce que** la couche intermédiaire est du nitrure de silicium (Si₃N₄) ou de l'oxynitrure de silicium (SiON).

5. Procédé suivant la revendication 2, **caractérisé en ce que** la couche conductrice est une couche métallique, par exemple en titane, en tungstène ou en TiW.

6. Procédé suivant l'une des revendications 1 à 5, **caractérisé en ce que** la face inférieure du substrat est protégée, avant que l'on effectue le stade d), d'une attaque le long de la bordure du substrat, par exemple par dépôt d'une couche de passivation ou par montage d'un cadre.

7. Procédé suivant l'une des revendications 1 à 6, **caractérisé en ce qu'**il est fixé sur le substrat, avant que l'on effectue l'un des stades b), c) ou d), un cadre (9) stable dans la région de la bordure du substrat.

8. Procédé suivant la revendication 7, **caractérisé en ce que** l'on choisit pour le cadre un anneau en Pyrex ou en silicium et on fixe cet anneau sur le substrat avant d'effectuer le stade b).
